# EUROPEAN PATENT APPLICATION

(11) **EP 4 790 435 A1**
(43) Date of publication of application: **12.08.2026**
(21) Application number: 25225408.1
(22) Date of filing: 19.12.2025
(51) Int. Cl.: G01R 31/28, G01R 31/303, G01R 33/10

(54) **METHOD AND SYSTEM OF RECONSTRUCTING ELECTRIC CURRENT FROM MAGNETIC FIELD MAPS OF 3D INTEGRATED CIRCUITS**

(30) Priority: 07.02.2025 IN 202521010551
(71) Applicant: Tata Consultancy Services Limited, Maharashtra (IN)
(72) Inventor: ANAND, Prabhat Sneh, 560066 Bengaluru, Karnataka (IN); SAHU, Saurabh, 560066 Bengaluru, Karnataka (IN); KUMAR, Kriti, 560009 Bengaluru, Karnataka (IN); CHANDRA, Mariswamy Girish, 560066 Bengaluru, Karnataka (IN)
(74) Representative: Goddar, Heinz J.

(57) **Abstract**

Existing methods have attempted 2D reconstruction of current for individual layers but not for 3D Integrated Circuits (ICs) non-invasively. Hence, embodiments of present disclosure provide a method and system of reconstructing electric current from 2-D magnetic field maps of 3D ICs. Initially, magnetic field maps of the 3D IC are measured from a certain distance using a sensor. The volume of the 3D IC is discretized into a multiple layers of equal width. Among these layers, the layers having a current flow are detected by firstly calculating current density maps associated with each of the layers using an iterative optimization technique, computing quality measures for each layer based on the current density maps and then eliminating the layers having the quality measures less than a predefined threshold value. Once the layers having current flow are detected, the current density maps for these layers are estimated using the iterative optimization technique.

## Description

### CROSS-REFERENCE TO RELATED APPLICATIONS AND PRIORITY

The present application claims priority to Indian application no. 202521010551 filed on February 7, 2025.

### TECHNICAL FIELD

The present invention generally relates to the field of computational imaging, and, more particularly, to a method and system of reconstructing electric current from magnetic field maps of 3D integrated circuits.

### BACKGROUND

Quantum sensing with NV (Nitrogen-Vacancy) centers in diamond represents a groundbreaking advancement in precision measurement. NV centers are specific defects within the diamond lattice where a nitrogen atom replaces a carbon atom, creating a vacancy adjacent to it. These centers exhibit remarkable quantum properties, such as spin states that are highly sensitive to external magnetic and electric fields. By using the NV centers as quantum sensors, it is possible to achieve unprecedented levels of accuracy in detecting magnetic fields, temperature variations, and even electric fields at the nanoscale. Once the magnetic fields are detected, it is also possible to obtain the current density maps producing these magnetic fields which are of great interest to the semiconductor industry. By reconstructing or reproducing current density vector maps in 3D non-destructively, defects can be detected in semiconductor ICs, especially ICs with 3D structure which generally comprises of multiple 2D layers stacked on the top of each other.

Currently, there doesn't exist any industrially used method for detecting 3D current flow non-invasively. Some of the works in literature have attempted simple 2D reconstruction but they are not capable of reconstructing current flow in 3D volume of ICs. One of the prior art references CN109839582A provides a magnetic imaging test method and a magnetic imaging test device for three-dimensional current of an integrated circuit, which can carry out magnetic imaging test on the three-dimensional current in the integrated circuit. However, this work requires knowledge of design layout of the circuit under test. Also, it needs to take multiple measurements of magnetic field using a movable platform that makes it difficult to maintain and calibrate. The prior art performs 2D reconstruction of current for single 2D layers not for the whole 3D ICs with layered structure using Fourier transform of images that doesn't work with noisy images and when sensor to sample distance is large.

### SUMMARY

Embodiments of the present disclosure present technological improvements as solutions to one or more of the above-mentioned technical problems recognized by the inventors in conventional systems. For example, in one embodiment, a method of reconstructing electric current from magnetic field maps of 3D integrated circuits is provided. The method includes obtaining a plurality of magnetic field maps along x-direction (*bₓ*) and y-direction (*b_{y}*) of a 3-Dimensional Integrated Circuit (IC), measured using a sensor. The volume of the 3D IC is discretized into a plurality of layers of equal width (Δz). Further, the method includes detecting one or more layers, from among the plurality of layers, comprising a current flow, by firstly calculating a plurality of current density maps along x-direction and y-direction based on the plurality of magnetic field maps, associated with each of the plurality of layers using an iterative optimization technique and then computing one or more quality measures associated with each of the plurality of layers based on the associated plurality of current density maps. The one or more of the plurality of layers having the associated one or more quality measures greater than a first threshold value are determined as comprising the current flow. Furthermore, the method includes estimating a current map for each of the one or more layers using the iterative optimization technique to obtain a 3D current map of the IC.

In another aspect, a system of reconstructing electric current from magnetic field maps of 3D integrated circuits is provided. The system includes: a memory storing instructions; one or more communication interfaces; one or more sensors; and one or more hardware processors coupled to the memory via the one or more communication interfaces, wherein the one or more hardware processors are configured by the instructions to obtain a plurality of magnetic field maps along x-direction (*bₓ*) and y-direction (*b_{y}*) of a 3-Dimensional Integrated Circuit (IC), measured using a sensor. The volume of the 3D IC is discretized into a plurality of layers of equal width (Δz). Further, the one or more hardware processors are configured by the instructions to detect one or more layers, from among the plurality of layers, comprising a current flow, by firstly calculating a plurality of current density maps along x-direction and y-direction based on the plurality of magnetic field maps, associated with each of the plurality of layers using an iterative optimization technique and then computing one or more quality measures associated with each of the plurality of layers based on the associated plurality of current density maps. The one or more of the plurality of layers having the associated one or more quality measures greater than a first threshold value are determined as comprising the current flow. Furthermore, the one or more hardware processors are configured by the instructions to estimate a current map for each of the one or more layers using the iterative optimization technique to obtain a 3D current map of the IC.

In yet another aspect, there are provided one or more non-transitory machine-readable information storage mediums comprising one or more instructions which when executed by one or more hardware processors cause a method of reconstructing electric current from magnetic field maps of 3D integrated circuits. The method includes obtaining a plurality of magnetic field maps along x-direction (*bₓ*) and y-direction (*b_{y}*) of a 3-Dimensional Integrated Circuit (IC), measured using a sensor. The volume of the 3D IC is discretized into a plurality of layers of equal width (Δz). Further, the method includes detecting one or more layers, from among the plurality of layers, comprising a current flow, by firstly calculating a plurality of current density maps along x-direction and y-direction based on the plurality of magnetic field maps, associated with each of the plurality of layers using an iterative optimization technique and then computing one or more quality measures associated with each of the plurality of layers based on the associated plurality of current density maps. The one or more of the plurality of layers having the associated one or more quality measures greater than a first threshold value are determined as comprising the current flow. Furthermore, the method includes estimating a current map for each of the one or more layers using the iterative optimization technique to obtain a 3D current map of the IC.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1 illustrates an exemplary block diagram of a system of reconstructing electric current from magnetic field maps of 3D Integrated Circuits (IC), according to some embodiments of the present disclosure.
FIG. 2 is a flow diagram illustrating a method of reconstructing electric current from magnetic field maps of 3D integrated circuits, according to some embodiments of the present disclosure.
FIG. 3 illustrates an example 3D IC coupled with a sensor, according to some embodiments of the present disclosure.
FIGS. 4A and 4B illustrate a plurality of magnetic field maps of a 3D IC measured using a quantum sensor, according to some embodiments of the present disclosure.
FIGS. 5A to 5H illustrate a plurality of current density maps of a plurality of layers of the 3D IC, according to some embodiments of the present disclosure.
FIGS. 6A to 6D illustrate plurality of estimated current maps of one or more of the plurality of layers of the 3D IC comprising a current flow, according to some embodiments of the present disclosure.
FIGS. 7A and 7B illustrate current flow of the one or more of the plurality of layers of the 3D IC, according to some embodiments of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

Detecting and estimating current flow (also referred to as reconstructing current flow) non-invasively is a challenging task. Currently available methods have attempted 2D reconstruction of current for single 2D layers but not for 3D Integrated Circuits (ICs). Hence, embodiments of present disclosure provide a method and system of reconstructing electric current from magnetic field maps of 3D integrated circuits. Initially, magnetic field maps along x-direction (*bₓ*) and y-direction (*b_{y}*) of a 3-Dimensional Integrated Circuit (IC) are measured using a sensor. The volume of the 3D IC is discretized into a multiple layers of equal width (z). Among these layers, the layers having a current flow are detected by firstly calculating current density maps along x-direction and y-direction associated with each of the layers using an iterative optimization technique, computing one or more quality measures for each layer based on the current density maps and then eliminating the layers having the quality measures less than a predefined threshold value. Once the layers having current flow are detected, the current density maps for these layers are estimated using the iterative optimization technique. Detection of current flow in 3D IC and estimation of current density maps is together referred to as reconstructing current flow. Thus, the embodiments of present disclosure provide a current reconstruction technique by jointly considering the magnetic field of the 3D IC along x and y directions, it doesn't require layer-wise magnetic field. Further, the disclosed method uses a robust optimization technique that works with large sensor-to-ICs distance and noise levels. Since the method uses a sensor such as a widefield magnetometer for measuring magnetic fields, no raster or movement of any sort is needed, thereby making it attractive and preferable for a portable package.

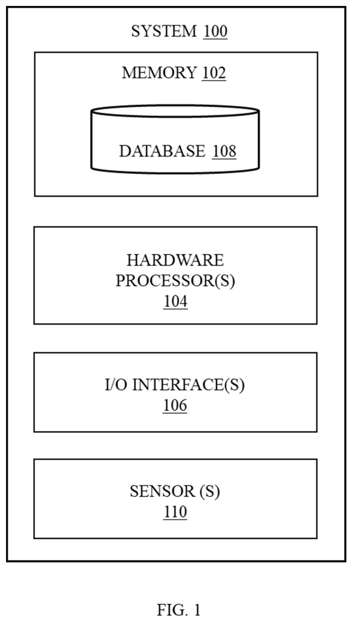

Referring now to the drawings, and more particularly to FIGS. 1 to 7B, where similar reference characters denote corresponding features consistently throughout the figures, there are shown preferred embodiments, and these embodiments are described in the context of the following exemplary system and/or method.

FIG. 1 illustrates an exemplary block diagram of a system of reconstructing electric current from magnetic field maps of 3D Integrated Circuits (IC), according to some embodiments of the present disclosure. In an embodiment, the system 100 includes one or more processors 104, communication interface device(s) 106 or Input/Output (I/O) interface(s) 106 or user interface 106, one or more data storage devices or memory 102 operatively coupled to the one or more processors 104, and one or more sensors 110 operatively coupled to the one or more processors 104. The one or more processors 104 that are hardware processors can be implemented as one or more microprocessors, microcomputers, microcontrollers, digital signal processors, central processing units, state machines, logic circuitries, and/or any devices that manipulate signals based on operational instructions. Among other capabilities, the processor(s) is configured to fetch and execute computer-readable instructions stored in the memory. In an embodiment, the system 100 can be implemented in a variety of computing systems, such as laptop computers, notebooks, hand-held devices, workstations, mainframe computers, servers, a network cloud, and the like.

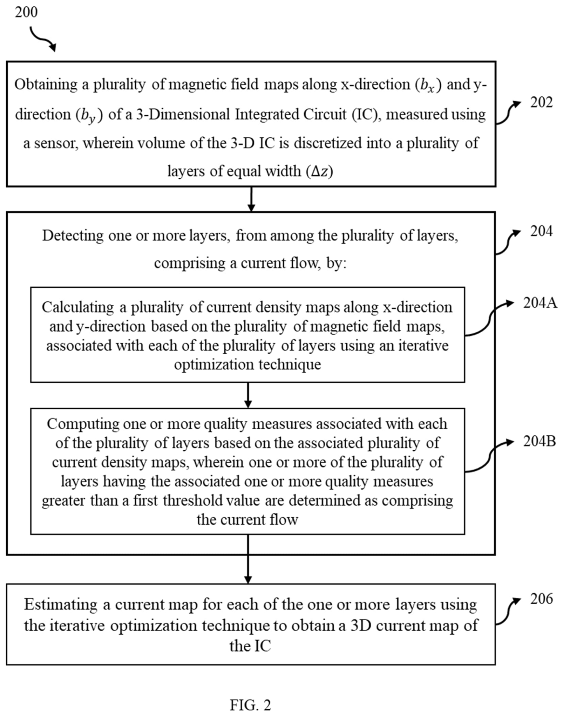

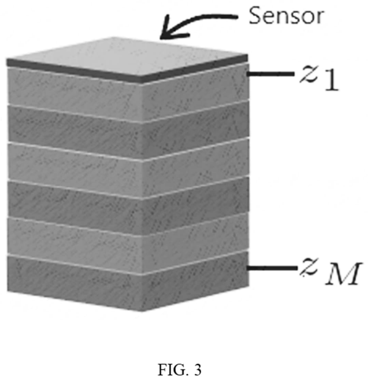

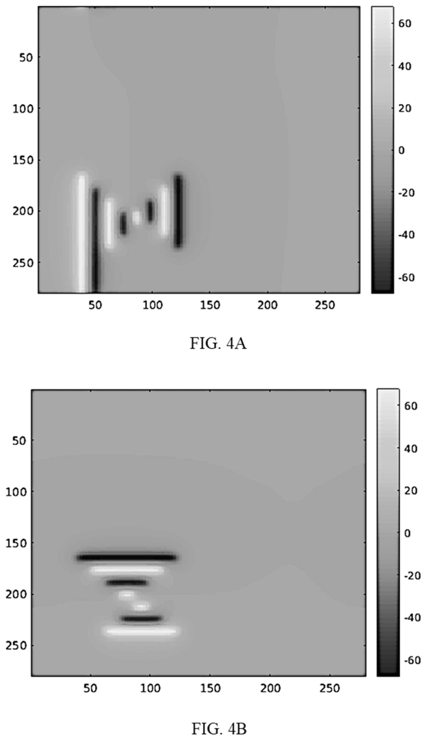

The I/O interface device(s) 106 can include a variety of software and hardware interfaces, for example, a web interface, a graphical user interface, and the like and can facilitate multiple communications within a wide variety of networks N/W and protocol types, including wired networks, for example, LAN, cable, etc., and wireless networks, such as WLAN, cellular, or satellite. The memory 102 may include any computer-readable medium known in the art including, for example, volatile memory, such as Static Random-Access Memory (SRAM) and Dynamic Random-Access Memory (DRAM), and/or non-volatile memory, such as read only memory (ROM), erasable programmable ROM, flash memories, hard disks, optical disks, and magnetic tapes. The database 108 stores information pertaining to inputs fed to the system 100 and/or outputs generated by the system (e.g., at each stage), specific to the methodology described herein. The one or more sensors 110 include sensors for measuring two or more components of magnetic field in 3D ICs, for example, quantum sensors, magnetometer and the like. Functions of the components of system 100 are explained in conjunction with flow diagram of FIG. 2, an example IC depicted in FIG. 3, and maps illustrated in FIGS. 4A to 7B for reconstructing electric current from magnetic field maps of 3D integrated circuits.

In an embodiment, the system 100 comprises one or more data storage devices or the memory 102 operatively coupled to the processor(s) 104 and is configured to store instructions for execution of steps of a method 200 depicted in FIG. 2 by the processor(s) or one or more hardware processors 104. The method 200 as in FIG. 2 illustrate reconstructing electric current from magnetic field maps of 3D integrated circuits, according to some embodiments of present disclosure. The steps of the method of the present disclosure will now be explained with reference to the components or blocks of the system 100 as depicted in FIG. 1, the flow diagram of FIG. 2, the example IC illustrated in FIG. 3 and maps illustrated in FIG. 4A to 7B for reconstructing electric current from magnetic field maps of 3D integrated circuits. Although process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any order practical. Further, some steps may be performed simultaneously.

At step 202 of the method 200, the one or more hardware processors 104 are configured to obtain a plurality of magnetic field maps along x-direction (*bₓ*) and y-direction (*b_{y}*) of a 3-Dimensional Integrated Circuit (IC), measured using a sensor. Volume of the 3D IC is discretized into a plurality of layers of equal width (Δz). An example 3D IC is illustrated in FIG. 3. The sensor is placed on top of the 3D IC to measure the magnetic field. The plurality of layers are made up of active electronic components, connected with vertical elements such as Through-Silicon Vias (TSVs). Stacking the plurality of layers on top of each other dramatically enhances chip performances by further improving the functionality of IC technology and reducing the design's complexity. Suppose volume of the 3D IC placed below the sensor is *Ω = L* × *L* × Z where Z is total depth of volume. The volume is discretized into *M* layers of equal width/depth (Δz) such that the layers are stacked upon each other to make up *Ω*. The sensor to layer distance of each layer is *zₘ* and corresponding kernel is *gₘ* where *m* ∈ {1,2, ..., *M*} and ${\sum }_{m = 1}^{M} Δ z = Z$.

Further, at step 204 of the method 200, the one or more hardware processors 104 are configured to detect one or more layers, from among the plurality of layers, comprising a current flow, by performing steps 204A and 204B. At step 204A, a plurality of current density maps along x-direction and y-direction are calculated based on the plurality of magnetic field maps, associated with each of the plurality of layers using an iterative optimization technique. The iterative optimization technique comprises iteratively optimizing a cost function using Alternating Direction Method of Multipliers (ADMM) until a difference between a plurality of current density maps estimated at subsequent iterations is smaller than a second threshold value. The cost function is given by equation 1, where m represents a *m^{th}* layer among the plurality of layers, *wₘ* is a tunable weight of the *m^{th}* layer calculated using Green's functions kernels *gₘ* corresponding to a convolution determined by Biot-Savart law for the *m^{th}* layer, ${j}_{m}^{x}$ represents a current density map estimated at x-direction of the *m^{th}* layer, ${j}_{m}^{y}$ represents a current density map estimated at y-direction of the *m^{th}* layer, and ∥.∥₁ denotes L₁ norm. $\begin{matrix}{argmin}_{\left\{{j}_{m}^{x}\right\} , \left\{{j}_{m}^{y}\right\}} \frac{1}{2} {\left‖{\sum }_{m} {g}_{m}∗{j}_{m}^{x}+{b}_{y}\right‖}_{2}^{2} + \frac{1}{2} {\left‖{\sum }_{m} {g}_{m}∗{j}_{m}^{y}-{b}_{x}\right‖}_{2}^{2} + {λ}_{1} {\sum }_{m} {\left‖{w}_{m}⊙{j}_{m}^{x}\right‖}_{1} + \\ {λ}_{2} {\sum }_{m} {\left‖{w}_{m}⊙{j}_{m}^{y}\right‖}_{1}\end{matrix}$

Choosing right tunable weights is very important for the method 200 to work properly. Different layers are identified and current in them is reconstructed with a high accuracy based on the tunable weights designed as a function of energy of the Green's functions kernels (alternatively referred to as kernel) *gₘ* i.e. $F \left({\left‖{g}_{m}\right‖}_{2}^{2}\right)$. The Green's functions kernels are derived by a convolution determined by Biot-Savart law. According to the Biot-Savart law, the magnetic field and corresponding current density is related through the relation given by equation 2, where J is the current density. $B \left(x\right) = \frac{{μ}_{0}}{4 π} {\int }_{Ω} J \left(x′\right) \times \frac{x - x ′}{{\left|x-x′\right|}^{3}} d x ′$

Assuming that z-component of *J* (i.e., current at z-direction) is zero and sample is layer-wise, relation in equation 2 becomes a convolution between Green's function and current density from a single layer at z as given by equations 3 and 4. Thus, the kernel for *m^{th}* layer is given by equation 5. ${B}_{x} \left(x, y, z\right) = \frac{{μ}_{0} z}{4 π} \int {\int }_{- ∞}^{+ ∞} \frac{{J}_{y} \left(x′,y′\right)}{{\left⌈\left.{\left(x-x′\right)}^{2}+{\left(y-y′\right)}^{2}+{z}^{2}\right)\right⌉}^{\frac{3}{2}}} dx ′ dy ′$ ${B}_{y} \left(x, y, z\right) = \frac{{μ}_{0} z}{4 π} \int {\int }_{- ∞}^{+ ∞} \frac{- {J}_{x} \left(x′,y′\right)}{{\left⌈\left.{\left(x-x′\right)}^{2}+{\left(y-y′\right)}^{2}+{z}^{2}\right)\right⌉}^{\frac{3}{2}}} dx ′ dy ′$ ${g}_{m} = \frac{{μ}_{0} {z}_{m}}{4 π} \frac{δx {′}^{2}}{{\left⌈{\left(x{′}_{i}\right)}^{2}+{\left(y{′}_{i}\right)}^{2}+{z}_{m}\right⌉}^{\frac{3}{2}}}$

The tunable weight *wₘ* of the *m^{th}* layer is in the form of equation 6. *εₘ* is a parameter to be optimized for each layer. The value of *εₘ* for each half discretization point (i.e., at each *zₘ* and ${z}_{m} + \frac{z}{2}$) is experimentally determined with an ensemble of test samples with varying feature sizes and geometries and current magnitude to consider all the possible variations of current carrying wires layout in the ICs. $\begin{matrix}{w}_{m} = {\left‖{g}_{m}\right‖}_{2}^{2} + {ε}_{m} , where {\left‖{g}_{m}\right‖}_{2}^{2} = {{\sum }_{i = 0}^{N} {\sum }_{j = 0}^{N} \left[\frac{{μ}_{0} {z}_{m}}{4 π}\frac{δx {′}^{2}}{{\left⌈{\left(x{′}_{i}\right)}^{2}+{\left(y{′}_{i}\right)}^{2}+{z}_{m}\right⌉}^{\frac{3}{2}}}\right]}^{2} and \\ {ε}_{m} > 0\end{matrix}$

The tunable weights determined according to equation 6 are used in the cost function of equation 1. The cost function is minimized using Alternating Direction Method of Multipliers (ADMM). Firstly, auxiliary variables ( ${v}_{m}^{x}$ and ${v}_{m}^{y}$) are introduced to the cost function by variable splitting method to get equation 7, where *λ*₁*, λ*₂ and rho (p) are hyperparameters associated with regularizer and proximal term respectively. Because of the symmetric distribution of *j*^{y} and *j^{x},* both hyperparameters (constants) are the same for both *j*^{y} and *j^{x}* pairs. $L \left(\left\{{j}_{m}^{x}, {v}_{m}^{x}, {u}_{m}^{x}\right\}, \left\{{j}_{m}^{y}, {v}_{m}^{y}, {u}_{m}^{y}\right\}\right) = \frac{1}{2} {\left‖{\sum }_{m} {g}_{m}∗{j}_{m}^{x}+{b}_{y}\right‖}_{2}^{2} + \frac{1}{2} {\left‖\begin{matrix}{\sum }_{m} {g}_{m} ∗ {j}_{m}^{y} - \\ {b}_{x}\end{matrix}\right‖}_{2}^{2} + {λ}_{1} {\sum }_{m} {\left‖{w}_{m}⊙{v}_{m}^{x}\right‖}_{1} + {λ}_{2} {\sum }_{m} {\left‖{w}_{m}⊙{v}_{m}^{y}\right‖}_{1} + \frac{ρ}{2} {\sum }_{m} {\left‖\begin{matrix}{j}_{m}^{x} - {v}_{m}^{x} + \\ {u}_{m}^{x}\end{matrix}\right‖}_{2}^{2} + \frac{ρ}{2} {\sum }_{m} {\left‖{j}_{m}^{y}-{v}_{m}^{y}+{u}_{m}^{y}\right‖}_{2}^{2}$

Once the auxiliary variables are introduced, following steps are carried out to solve the optimization problem (i.e. minimizing the cost function of equation 1). Step 1: Update $\left\{{j}_{m}^{x}\right\}$ and $\left\{{j}_{m}^{y}\right\}$: $\left\{{j}_{m}^{x}\right\} = {arg min}_{\left\{{j}_{m}^{x}\right\}} \frac{1}{2} {\left‖{\sum }_{m} {g}_{m}∗{j}_{m}^{x}+{b}_{y}\right‖}_{2}^{2} + \frac{ρ}{2} {\sum }_{m} {\left‖{j}_{m}^{x}-{v}_{m}^{x}+{u}_{m}^{x}\right‖}_{2}^{2}$ $\left\{{j}_{m}^{y}\right\} = {arg min}_{\left\{{j}_{m}^{x}\right\}} \frac{1}{2} {\left‖{\sum }_{m} {g}_{m}∗{j}_{m}^{y}-{b}_{x}\right‖}_{2}^{2} + \frac{ρ}{2} {\sum }_{m} {\left‖{j}_{m}^{y}-{v}_{m}^{y}+{u}_{m}^{y}\right‖}_{2}^{2}$ Defining *gₘ* as a linear operator such that ${G}_{m} {j}_{m}^{x} = {g}_{m} ∗ {j}_{m}^{x}$*, G =* (*G*₀ *G*₁ *....* )*,* ${j}^{x} =$ ${\left({j}_{0}^{x}{j}_{1}^{x}….\right)}^{T} , {v}^{x} = {\left({v}_{0}^{x}{v}_{1}^{x}….\right)}^{T}$, and ${u}^{x} = {\left({u}_{0}^{x}{u}_{1}^{x}….\right)}^{T}$*,* equations 8 and 9 are rewritten in matrix form as equations 10 and 11. ${j}^{x} = {arg min}_{{j}^{x}} \frac{1}{2} {\left‖{Gj}^{x}+{b}_{y}\right‖}_{2}^{2} + \frac{ρ}{2} {\left‖{j}^{x}-{v}^{x}+{u}^{x}\right‖}_{2}^{2}$ ${j}^{y} = {arg min}_{{j}^{y}} \frac{1}{2} {\left‖{Gj}^{y}-{b}_{x}\right‖}_{2}^{2} + \frac{ρ}{2} {\left‖{j}^{y}-{v}^{y}+{u}^{y}\right‖}_{2}^{2}$ The closed form solution for equations 10 and 11 can be derived in Fourier domain using Fast Fourier Transform (FFT) and Sherman Morrison Formula as given by equations 12 and 13. $\left({G}^{T}G+ρI\right) {j}^{x} = - {G}^{T} {b}_{y} + ρ \left({v}^{x}-{u}^{x}\right)$ $\left({G}^{T}G+ρI\right) {j}^{y} = {G}^{T} {b}_{x} + ρ \left({v}^{y}-{u}^{y}\right)$ Step 2: Update $\left\{{v}_{m}^{x}\right\}$ and $\left\{{v}_{m}^{y}\right\}$: ${v}_{m}^{x} = {arg min}_{{v}_{m}^{x}} {λ}_{1} {\sum }_{m} {\left‖{w}_{m}⊙{v}_{m}^{x}\right‖}_{1} + \frac{ρ}{2} {\sum }_{m} {\left‖{j}_{m}^{x}-{v}_{m}^{x}+{u}_{m}^{x}\right‖}_{2}^{2}$ ${v}_{m}^{y} = {arg min}_{{v}_{m}^{y}} {λ}_{2} {\sum }_{m} {\left‖{w}_{m}⊙{v}_{m}^{y}\right‖}_{1} + \frac{ρ}{2} {\sum }_{m} {\left‖{j}_{m}^{y}-{v}_{m}^{y}+{u}_{m}^{y}\right‖}_{2}^{2}$ The closed form update for equations 14 and 15 are obtained as equations 16 and 17. ${v}_{m}^{x} = {S}_{\left({w}_{m}{λ}_{1}\right) / ρ} \left({j}_{m}^{x}+{u}_{m}^{x}\right)$ ${v}_{m}^{y} = {S}_{\left({w}_{m}{λ}_{2}\right) / ρ} \left({j}_{m}^{y}+{u}_{m}^{y}\right)$ In equations 16 and 17, *S*_{γ}(·) is a soft thresholding function expressed as in equation 18. ${S}_{γ} \left(V\right) = sign \left(V\right) ⊙ max \left(0,\left|V\right|-γ\right)$ Step 3: Update dual variables ${u}_{m}^{x} = {u}_{m}^{x} + {j}_{m}^{x} - {v}_{m}^{x}$ ${u}_{m}^{y} = {u}_{m}^{y} + {j}_{m}^{y} - {v}_{m}^{y}$ It is to be noted that in steps 2 and 3, the operations are performed layer-wise, hence, no vectorization is needed. All six variables *j^{x}, j^{y}, v^{x}, v^{y}, u^{x}* and *u^{y}* are initialized based on an initial guess or randomly. This decision is based on the particular case under consideration. If the user have some initial guess of the output, then the variables are initiated according to it otherwise they are randomly initialized and iterated over to get the best estimation. Hyperparameters of the algorithm like *λ*₁, *λ*₂ and *ρ* are chosen empirically and kept the same throughout the iterative optimization. *gₘ*'s are Green's function constraining the information of convolution and *bₓ* and *b_{y}* are taken as input to the iterative optimization technique. Then steps 1, 2 and 3 are repeated sequentially until a difference between a plurality of current density maps estimated at subsequent iterations is smaller than a second threshold value. After each iteration, the new pair of current density maps *j^{x}* and *j^{y}* are calculated. The output of the immediate previous iteration is also saved. If the current estimate does not change significantly, i.e., the difference between current density maps of previous and current iteration is below the second threshold value, then the minimization is assumed to have converged, and the iterative optimization process is stopped. The second threshold value is determined heuristically depending on the practical application.

Once the plurality of current density maps along x-direction and y-direction associated with each of the plurality of layers are calculated based on the plurality of magnetic field maps, at step 204B of the method 200, the one or more hardware processors 104 are configured to compute one or more quality measures associated with each of the plurality of layers based on the associated plurality of current density maps. The one or more quality measures comprises of manual testing with visual inspection along with various domain related quantitative measures like i) total energy of current values, ii) accuracy of total current measured magnitude that flows in the layer, iii) continuity of current flow and the like. The total energy of current values is calculated as squared sum of all current values. The accuracy of total current measured magnitude that flows in the layers is determined based on correct values of total current injected in ICs given by manufacturers. Current flowing in each layer is determined by combining current densities calculated at x and y directions and compared with the correct values to determine the accuracy of current measured. The continuity of current flow is determined by ensuring that current flow path is complete, i.e., there is no unphysical source and sink coming up in the current density maps. Similar quality measures may be used in other embodiments to measure quality of the calculated current density maps. The one or more of the plurality of layers having the associated one or more quality measures greater than a first threshold value are determined as comprising the current flow. The layers having one or more quality measures lesser than the first threshold value are eliminated and only the layers comprising current flow are retained for further processing.

Suppose the one or more layers comprising the current flow include adjacent layers, then, step 204A is repeated after re-discretizing width of each of the plurality of layers by a value equal to z shifted by $\frac{z}{2}$ from previous discretization to identify an exact region of current flow. For example, suppose the layers are considered at positions *z*₁, *z*₂ and so on. Now, it will be ${z}_{1} + \frac{z}{2}$, ${z}_{2} + \frac{z}{2}$ and so on. Same goes with ${z}_{1} - \frac{z}{2} , {z}_{2} - \frac{z}{2}$ and so on. If the current is still found out to be in any two adjacent layers, it is concluded that two layers are present. Exact discretization is chosen based on the reconstruction quality. This quality measure comprises of manual testing along with various domain related quantitative measures like accuracy to total current measured and continuity of current flow. But after the shift, if one layer comes out to be having the current, then that layer is concluded to have the current flow.

Once the one or more layers comprising current flow are detected, at step 206 of the method 200, the one or more hardware processors 104 are configured to estimate a current map for each of the one or more layers using the iterative optimization technique to obtain a 3D current map of the IC. The same iterative optimization technique performed in step 204A is executed only on the selected layers comprising current flow and with a different choice of hyperparameters *λ*₁, *λ*₂ and *ρ*. Determination of these hyperparameters is empirical and is selected based on the practical application.

The method 200 provides an end-to-end framework for reconstructing 3D current i.e., detecting current flow and estimating 3D current densities in the layers of 3D IC by directly processing the magnetic field maps. Unlike the prior arts, the method 200 doesn't need the phantoms (visual model of 3D ICs) in the processing part and is mostly blind on the geometrical configuration of ICs samples. Hence, it can be easily applied on various 3D ICs available in the industry.

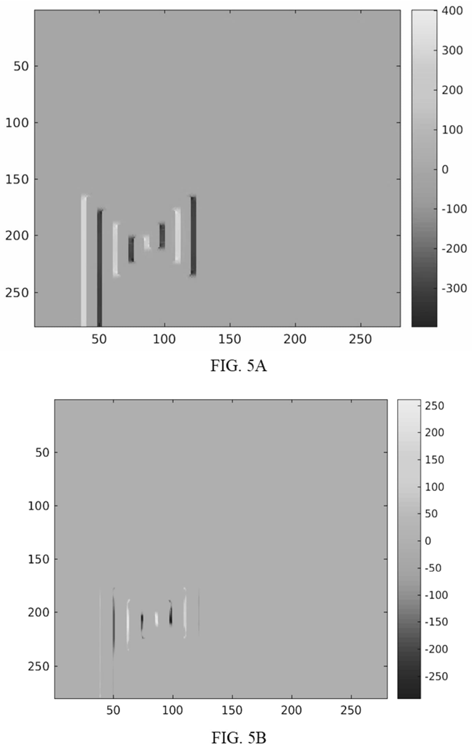

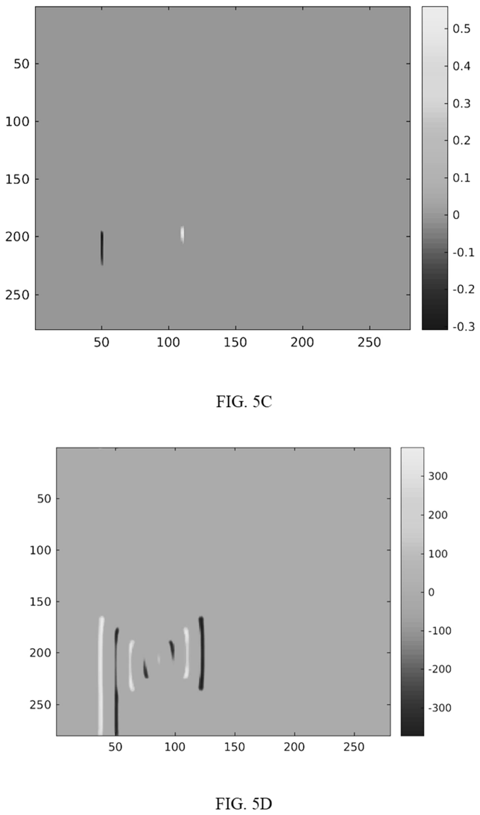

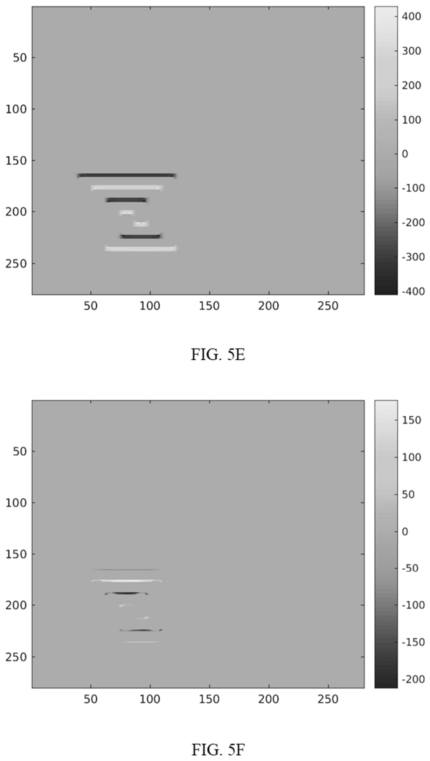

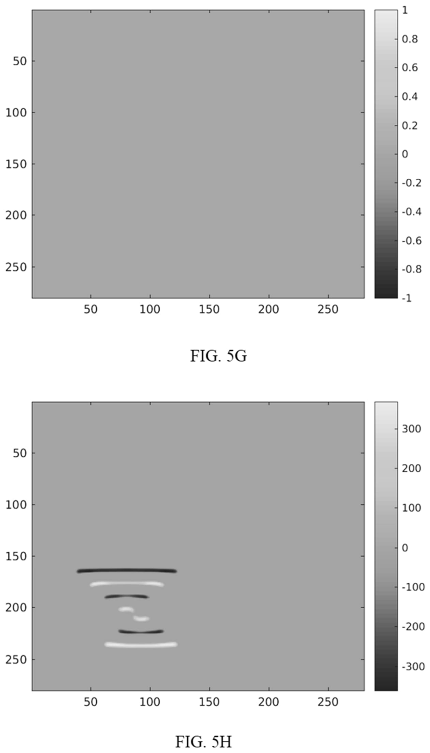

USE CASE EXAMPLE: The method 200 is implemented on an example 3D IC. Firstly, a plurality of magnetic field maps are obtained_along x-direction (*bₓ*) and y-direction (*b_{y}*) of the 3D IC using a quantum sensor. FIGS. 4A and 4B illustrate *bₓ* and *b_{y},* respectively, according to some embodiments of the present disclosure. Volume of the 3D IC is discretized into 4 layers with distance of 1µm each (i.e., Δz = 1µm). Next, among the 4 layers, the layers comprising current flow are detected by firstly calculating a plurality of current density maps along x-direction and y-direction based on the plurality of magnetic field maps, associated with each of the layers using the iterative optimization technique. FIGS. 5A to 5D illustrate the plurality of current density maps calculated along x-direction (*Jₓ*) for layers 1 to 4, respectively. Similarly, FIGS. 5E to 5H illustrate the plurality of current density maps calculated along y-direction (*J_{y}*) for layers 1 to 4, respectively. Tunable weights for the iterative optimization are chosen from a set of optimized weights on a different set of magnetic field images. It can be observed from FIGS. 5A to 5H that only layers 1 and 4 comprise current flow. Further, energy values of all the layers are computed from the current density maps and the results are given in Table 1.

**Table 1**

| | **Layer 1** | **Layer 2** | **Layer 3** | **Layer4** |
|---|---|---|---|---|
| **Standoff (µm)** | 2 | 3 | 4 | 5 |
| **Energy values** | 1.02E+08 | 4.75E+05 | 0.00E+00 | 1.32E+08 |

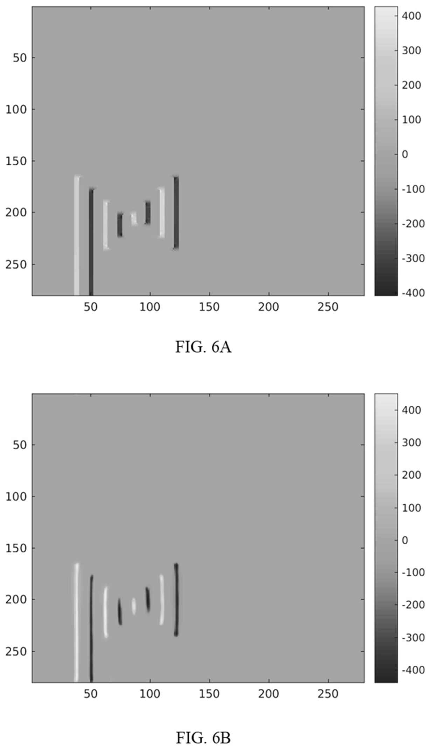

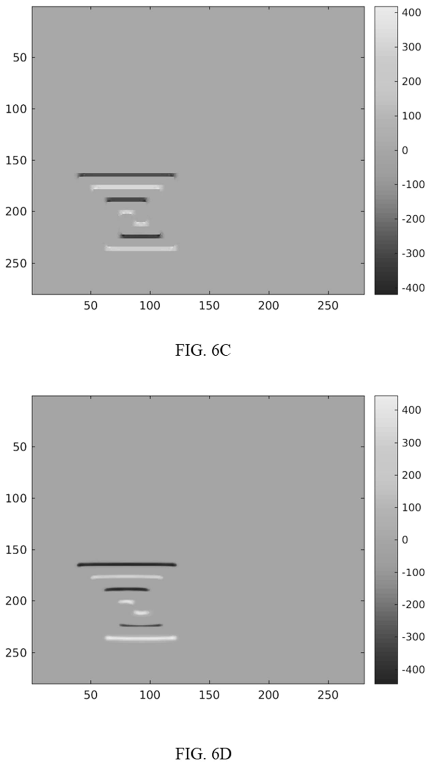

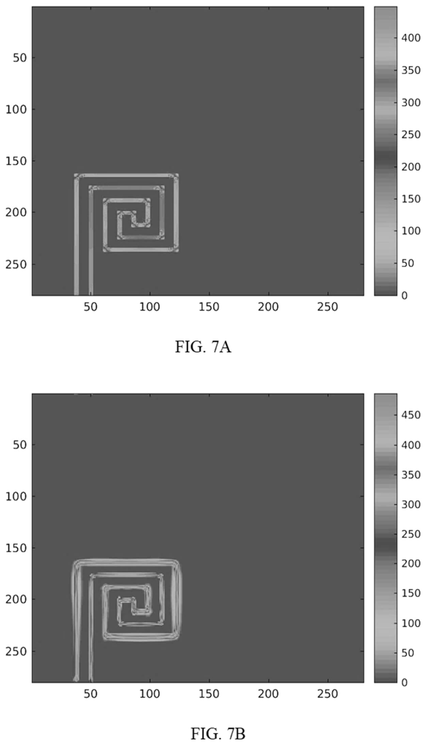

From Table 1, it can be observed that only layers 1 and 4 have energy values above the second threshold of 1.0E+07 considered in this example. Hence, only layers 1 and 4 comprise current flow. Finally, current map of layers 1 and 4 are estimated using the iterative optimization technique. FIGS. 6A and 6B illustrate the current maps estimated at x-direction for layers 1 and 4, respectively. Similarly, FIGS. 6C and 6D illustrate the current maps estimated at y-direction for layers 1 and 4, respectively. For better visualization of current flow, magnitude or absolute values of current density are determined from its x and y components according to equation 21. FIGS. 7A and 7B illustrate current flow at layer 1 and 4, respectively. Depending on the application like defect detection, the current flow images can be further analyzed for any localization and design vulnerabilities using standard fault analysis techniques. $J = \sqrt{{{J}_{x}}^{2} + {{J}_{y}}^{2}}$

PRACTICAL APPLICATION: The method 200 is valuable in the semiconductor industry, where non-destructive investigation of faults in semiconductor chips is of paramount importance. For a given layout of 3D IC and for a known current flowing through the IC (producing the current densities *Jₓ*, *J_{y}* and *J_{z}*), the magnetic field *Bₓ, B_{y}* and *B_{z}* that can be expected at any given stand-off distance is determined. The defects, if any, in a new batch of ICs can be detected by comparing the current density maps obtained from the measured magnetic field against the expected current density maps. If the deviation is beyond a certain set limit, it would indicate a defect in the IC, and probably an error in the fabricating process. But to go beyond this simple change detection and locating specific defects or vulnerable sites, reconstructed maps of electric current density from magnetic field measurement need to be analyzed and fixed in development phase.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an applicationspecific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computerusable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, non-volatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (200), comprising:
obtaining (202), via one or more hardware processors, a plurality of magnetic field maps along x-direction (*bₓ*) and y-direction (*b_{y}*) of a 3-Dimensional Integrated Circuit (IC), measured using a sensor, wherein volume of the 3D IC is discretized into a plurality of layers of equal width (Δz);
detecting (204), via the one or more hardware processors, one or more layers, from among the plurality of layers, comprising a current flow, by:
calculating (204A) a plurality of current density maps along x-direction and y-direction based on the plurality of magnetic field maps, associated with each of the plurality of layers using an iterative optimization technique; and
computing (204B) one or more quality measures associated with each of the plurality of layers based on the associated plurality of current density maps, wherein one or more of the plurality of layers having the associated one or more quality measures greater than a first threshold value are determined as comprising the current flow; and
estimating (206), via the one or more hardware processors, a current map for each of the one or more layers using the iterative optimization technique to obtain a 3D current map of the IC.

2. The method as claimed in claim 1, wherein the iterative optimization technique comprises iteratively optimizing a cost function using Alternating Direction Method of Multipliers (ADMM) until a difference between a plurality of current density maps estimated at subsequent iterations is smaller than a second threshold value, and wherein the cost function is given by: ${argmin}_{\left\{{j}_{m}^{x}\right\} , \left\{{j}_{m}^{y}\right\}} \frac{1}{2} {\left‖{\sum }_{m} {g}_{m} ∗ {j}_{m}^{x} + {b}_{y}\right‖}_{2}^{2} +$ $\frac{1}{2} {\left‖{\sum }_{m} {g}_{m} ∗ {j}_{m}^{y} - {b}_{x}\right‖}_{2}^{2} + {λ}_{1} {\sum }_{m} {\left‖{w}_{m}⊙{j}_{m}^{x}\right‖}_{1} + {λ}_{2} {\sum }_{m} {\left‖{w}_{m}⊙{j}_{m}^{y}\right‖}_{1}$, where m represents a *m^{th}* layer among the plurality of layers, *wₘ* is a tunable weight of the *m^{th}* layer calculated using Green's functions kernels *gₘ* corresponding to a convolution determined by Biot-Savart law for the *m^{th}* layer, ${j}_{m}^{x}$ represents a current density map estimated at x-direction of the *m^{th}* layer, ${j}_{m}^{y}$ represents a current density map estimated at y-direction of the *m^{th}* layer, and ∥.∥₁ denotes L₁ norm.

3. The method as claimed in claim 1, wherein if the one or more layers comprising the current flow include adjacent layers, then, repeating the step of determining one or more layers comprising the current flow after re-discretizing width of each of the plurality of layers by a value equal to z shifted by $\frac{z}{2}$ from previous discretization to identify an exact region of current flow.

4. A system (100), comprising:
a memory (102) storing instructions;
one or more Input/Output (I/O) interfaces (106);
one or more sensors (110); and
one or more hardware processors (104) coupled to the memory (102) and the one or more sensors (110) via the one or more communication interfaces (106),
wherein the one or more hardware processors (104) are configured by the instructions to:
obtain a plurality of magnetic field maps along x-direction (*bₓ*) and y-direction (*b_{y}*) of a 3-Dimensional Integrated Circuit (IC), measured using the one or more sensors, wherein volume of the 3D IC is discretized into a plurality of layers of equal width (Δz);
detect one or more layers, from among the plurality of layers, comprising a current flow, by:
calculating a plurality of current density maps along x-direction and y-direction based on the plurality of magnetic field maps, associated with each of the plurality of layers using an iterative optimization technique; and
computing one or more quality measures associated with each of the plurality of layers based on the associated plurality of current density maps, wherein one or more of the plurality of layers having the associated one or more quality measures greater than a first threshold value are determined as comprising the current flow; and
estimate a current map for each of the one or more layers using the iterative optimization technique to obtain a 3D current map of the IC.

5. The system as claimed in claim 4, wherein the iterative optimization technique comprises iteratively optimizing a cost function using Alternating Direction Method of Multipliers (ADMM) until a difference between a plurality of current density maps estimated at subsequent iterations is smaller than a second threshold value, and wherein the cost function is given by: ${argmin}_{\left\{{j}_{m}^{x}\right\} , \left\{{j}_{m}^{y}\right\}} \frac{1}{2} {\left‖{\sum }_{m} {g}_{m} ∗ {j}_{m}^{x} + {b}_{y}\right‖}_{2}^{2} + \frac{1}{2} {\left‖{\sum }_{m} {g}_{m} ∗ {j}_{m}^{y} - {b}_{x}\right‖}_{2}^{2} + {λ}_{1} {\sum }_{m} {\left‖{w}_{m}⊙{j}_{m}^{x}\right‖}_{1} + {λ}_{2} {\sum }_{m} {\left‖{w}_{m}⊙{j}_{m}^{y}\right‖}_{1}$ , where m represents a *m^{th}* layer among the plurality of layers, *wₘ* is a tunable weight of the *m^{th}* layer calculated using Green's functions kernels *gₘ* corresponding to a convolution determined by Biot-Savart law for the *m^{th}* layer, ${j}_{m}^{x}$ represents a current density map estimated at x-direction of the *m^{th}* layer, ${j}_{m}^{y}$ represents a current density map estimated at y-direction of the *m^{th}* layer, and ∥.∥₁ denotes L₁ norm.

6. The system as claimed in claim 4, wherein if the one or more layers comprising the current flow include adjacent layers, then, repeating the step of determining one or more layers comprising the current flow after re-discretizing width of each of the plurality of layers by a value equal to z shifted by $\frac{z}{2}$ from previous discretization to identify an exact region of current flow.

7. One or more non-transitory machine-readable information storage mediums comprising one or more instructions which when executed by one or more hardware processors cause:
obtaining a plurality of magnetic field maps along x-direction (*bₓ*) and y-direction (*b_{y}*) of a 3-Dimensional Integrated Circuit (IC), measured using the one or more sensors, wherein volume of the 3D IC is discretized into a plurality of layers of equal width (Δz);
detecting one or more layers, from among the plurality of layers, comprising a current flow, by:
calculating a plurality of current density maps along x-direction and y-direction based on the plurality of magnetic field maps, associated with each of the plurality of layers using an iterative optimization technique; and
computing one or more quality measures associated with each of the plurality of layers based on the associated plurality of current density maps, wherein one or more of the plurality of layers having the associated one or more quality measures greater than a first threshold value are determined as comprising the current flow; and
estimating a current map for each of the one or more layers using the iterative optimization technique to obtain a 3D current map of the IC.

8. The one or more non-transitory machine-readable information storage mediums as claimed in claim 7, wherein the iterative optimization technique comprises iteratively optimizing a cost function using Alternating Direction Method of Multipliers (ADMM) until a difference between a plurality of current density maps estimated at subsequent iterations is smaller than a second threshold value, and wherein the cost function is given by: ${argmin}_{\left\{{j}_{m}^{x}\right\} , \left\{{j}_{m}^{y}\right\}} \frac{1}{2} {\left‖{\sum }_{m} {g}_{m} ∗ {j}_{m}^{x} + {b}_{y}\right‖}_{2}^{2} + \frac{1}{2} {\left‖{\sum }_{m} {g}_{m} ∗ {j}_{m}^{y} - {b}_{x}\right‖}_{2}^{2} + {λ}_{1} {\sum }_{m} {\left‖{w}_{m}⊙{j}_{m}^{x}\right‖}_{1} + {λ}_{2} {\sum }_{m} {\left‖{w}_{m}⊙{j}_{m}^{y}\right‖}_{1}$ , where m represents a *m^{th}* layer among the plurality of layers, *wₘ* is a tunable weight of the *m^{th}* layer calculated using Green's functions kernels *gₘ* corresponding to a convolution determined by Biot-Savart law for the *m^{th}* layer, ${j}_{m}^{x}$ represents a current density map estimated at x-direction of the *m^{th}* layer, ${j}_{m}^{y}$ represents a current density map estimated at y-direction of the *m^{th}* layer, and ∥.∥₁ denotes L₁ norm.

9. The one or more non-transitory machine-readable information storage mediums as claimed in claim 7, wherein if the one or more layers comprising the current flow include adjacent layers, then, repeating the step of determining one or more layers comprising the current flow after re-discretizing width of each of the plurality of layers by a value equal to z shifted by $\frac{z}{2}$ from previous discretization to identify an exact region of current flow.
